# EUROPEAN PATENT APPLICATION

(11) **EP 4 546 982 A2**
(43) Date of publication of application: **30.04.2025**
(21) Application number: 25163004.2
(22) Date of filing: 11.03.2025
(51) Int. Cl.: H10F 77/30, H10F 71/00

(54) **SOLAR CELL, METHOD FOR MANUFACTURING THE SAME, AND PHOTOVOLTAIC MODULE**

(30) Priority: 27.09.2024 CN 202411360281
(71) Applicant: Trina Solar Co., Ltd, Changzhou, Jiangsu 213031 (CN)
(72) Inventor: LIU, Chengfa, 213031 Changzhou (CN); LV, Dongyun, 213031 Changzhou (CN); HUANG, Jian, 213031 Changzhou (CN); CHEN, Daming, 213031 Changzhou (CN)
(74) Representative: Arnold & Siedsma

(57) **Abstract**

The present application relates to a solar cell, a method for manufacturing the same, and a photovoltaic module. A method includes: providing a semiconductor substrate (100); forming a tunnel layer (200) on a surface of the semiconductor substrate (100); sequentially forming an undoped initial intrinsic material layer (310) and a doped layer (401) including a dopant on a surface of the tunnel layer (200); the dopant including either an N-type dopant or a P-type dopant; and performing heat treatment on the initial intrinsic material layer (310) and the doped layer (401) to diffuse the dopant in the doped layer (401) to the initial intrinsic material layer (310) and at least partially crystallize the initial intrinsic material layer (310), so as to convert the initial intrinsic material layer (310) into a doped passivation layer (320).

## Description

### TECHNICAL FIELD

The present application relates to the field of photovoltaic technologies, and in particular, to a solar cell, a method for manufacturing the same, and a photovoltaic module.

### BACKGROUND

With the continuous development of a solar cell technology, people also have increasingly higher requirements for photoelectric conversion efficiency of solar cells. However, at present, improvement of efficiency of industrial solar cells still faces many challenges. In order to improve performance of the solar cell, a semiconductor substrate may generally be passivated. That is, a passivated contact structure is formed on a surface of the semiconductor substrate to reduce recombinations of surface carriers, thereby reducing an influence of internal defects in the semiconductor substrate on device performance. Therefore, how to further improve passivation performance of the passivated contact structure has become a research focus for those skilled in the art.

### SUMMARY

According to various embodiments of the present application, a solar cell with better passivation performance, a method for manufacturing the same, and a photovoltaic module are provided.

In a first aspect, embodiments of the present application provide a method for manufacturing a solar cell, including:
providing a semiconductor substrate;
forming a tunnel layer on a surface of the semiconductor substrate;
sequentially forming an undoped initial intrinsic material layer and a doped layer including a dopant on a surface of the tunnel layer; the dopant including either an N-type dopant or a P-type dopant; and
performing heat treatment on the initial intrinsic material layer and the doped layer to diffuse the dopant in the doped layer to the initial intrinsic material layer and at least partially crystallize the initial intrinsic material layer, so as to convert the initial intrinsic material layer into a doped passivation layer.

In an embodiment, sequentially forming the undoped initial intrinsic material layer and the doped layer including the dopant on the surface of the tunnel layer includes:
alternately forming a plurality of undoped initial intrinsic material layers and a plurality of doped layers including the dopants on the surface of the tunnel layer.

In an embodiment, one of the plurality of doped layers that is furthest from the semiconductor substrate is defined as a first doped layer, and another doped layer except the first doped layer is defined as a second doped layer;
the first doped layer has a thickness ranging from 5 nm to 30 nm; and/or
the second doped layer has a thickness ranging from 1 nm to 10 nm.

In an embodiment, when the thickness of the first doped layer is less than 10 nm, the method further includes:
forming a mask layer on a surface of the first doped layer; a sum of thicknesses of the mask layer and the first doped layer being greater than 20 nm.

In an embodiment, the mask layer is made of an undoped silicon compound.

In an embodiment, one of the plurality of doped layers that is furthest from the semiconductor substrate is defined as a first doped layer, and another doped layer except the first doped layer is defined as a second doped layer.

Doping concentration of the second doped layer is greater than doping concentration of a first doped layer.

In an embodiment, the method further includes:
subsequent to performing heat treatment on the initial intrinsic material layer and the doped layer, removing a barrier layer formed by conversion of a first doped layer during the heat treatment.

The first doped layer is one of the plurality of doped layers that is furthest from the semiconductor substrate.

In an embodiment, one of the plurality of doped layers that is furthest from the semiconductor substrate is defined as a first doped layer, and another doped layer except the first doped layer is defined as a second doped layer.

A thickness of the first doped layer is greater than a thickness of the tunnel layer, and a thickness of the second doped layer is greater than or equal to the thickness of the tunnel layer.

In an embodiment, the doped layer and the tunnel layer are made of silicon oxide compounds. One of the plurality of doped layers that is furthest from the semiconductor substrate is defined as a first doped layer, and another doped layer except the first doped layer is defined as a second doped layer.

A silicon-to-oxygen ratio of a second doped layer is greater than or equal to a silicon-to-oxygen ratio of a first doped layer and the tunnel layer.

In an embodiment, the silicon-to-oxygen ratio of the second doped layer is greater than 1:2, and the silicon-to-oxygen ratio of the tunnel layer is less than 1:5.

In an embodiment, the tunnel layer has a thickness ranging from 0.5 nm to 2 nm.

In an embodiment, sequentially forming the undoped initial intrinsic material layer and the doped layer including the dopant on the surface of the tunnel layer includes:
forming the initial intrinsic material layer and the doped layer on the surface of the tunnel layer in a same plasma enhanced chemical vapor deposition (PECVD) device.

In an embodiment, doping concentration of the doped layer is greater than 1e21 atoms/cm³.

In an embodiment, the heat treatment is further configured to diffuse the dopant into the semiconductor substrate to form an inner expansion layer in the semiconductor substrate.

In an embodiment, conditions of the heat treatment include a heat treatment temperature greater than 800°C and a heat treatment time greater than 20 min.

In an embodiment, the inner expansion layer has a thickness ranging from 0.02 µm to 1 µm.

In an embodiment, the initial intrinsic material layer is made of any one of intrinsic amorphous silicon, intrinsic microcrystalline silicon, and intrinsic polycrystalline silicon.

In an embodiment, the method further includes:
forming a buffer layer in the initial intrinsic material layer; the buffer layer including an undoped silicon compound.

Performing heat treatment on the initial intrinsic material layer and the doped layer includes:
performing heat treatment on the initial intrinsic material layer, the buffer layer, and the doped layer; the heat treatment including a plurality of treatment stages, temperatures in the plurality of treatment stages being not exactly the same.

In an embodiment, the heat treatment includes a first treatment stage and a second treatment stage performed sequentially. A temperature in the second treatment stage is greater than a temperature in the first treatment stage, or the temperature in the second treatment stage is less than the temperature in the first treatment stage.

In an embodiment, 800°C to 910°C is adopted in one of the first treatment stage and the second treatment stage, and 900°C to 1000°C is adopted in another of the first treatment stage and the second treatment stage.

In an embodiment, the heat treatment includes a first treatment stage, a second treatment stage, and a third treatment stage performed sequentially. A temperature in the second treatment stage is greater than a temperature in the first treatment stage and is greater than a temperature in the third treatment stage.

In an embodiment, when a plurality of initial intrinsic material layers are provided, forming the buffer layer in the initial intrinsic material layer includes:
forming the buffer layer in one of the initial intrinsic material layers that is closest to the semiconductor substrate.

In an embodiment, the buffer layer has a thickness ranging from 0.5 nm to 2 nm.

In an embodiment, the buffer layer is made of a silicon oxide compound.

In an embodiment, the method further includes:
forming a dielectric layer on a side of the doped passivation layer away from the semiconductor substrate; and
forming a first electrode on the side of the doped passivation layer away from the semiconductor substrate; a first end of the first electrode extending through the dielectric layer and being electrically connected to the doped passivation layer, and a second end of the first electrode extending in a direction away from the semiconductor substrate.

In an embodiment, when a plurality of doped passivation layers are provided, the first end of the first electrode extends to a target doped passivation layer of the plurality of doped passivation layers and extends through respective layers on a side of the target doped passivation layer away from the semiconductor substrate.

In a second aspect, embodiments of the present application provide a solar cell, manufactured by using the method as described above.

In a third aspect, embodiments of the present application provide a solar cell, including:
a semiconductor substrate;
a tunnel layer located on a surface of the semiconductor substrate;
a doped passivation layer stacked on a side of the tunnel layer away from the semiconductor substrate;
a dielectric layer disposed on a side of the doped passivation layer away from the tunnel layer; and
a first electrode, a first end of the first electrode being electrically connected to the doped passivation layer and extending through the dielectric layer, and a second end of the first electrode extending in a direction away from the semiconductor substrate.

In an embodiment, a plurality of doped passivation layers are provided. The solar cell further includes at least one barrier layer. The barrier layer is located on a side of any of the doped passivation layers away from the semiconductor substrate.

The first end of the first electrode extends to a target doped passivation layer of the plurality of doped passivation layers and extends through respective layers on a side of the target doped passivation layer away from the semiconductor substrate. The layers through which the first electrode extends include the dielectric layer.

In an embodiment, the layers through which the first electrode extends further include at least one of the doped passivation layers and/or the at least one barrier layer.

In an embodiment, the barrier layer has a thickness ranging from 0.5 nm to 10 nm.

In an embodiment, a thickness of the doped layer is greater than or equal to a thickness of the tunnel layer.

In an embodiment, the tunnel layer has a thickness ranging from 0.5 nm to 2 nm.

In an embodiment, the doped passivation layer has a single-layer thickness ranging from 2 nm to 150 nm.

In a fourth aspect, embodiments of the present application provide a photovoltaic module, including a solar cell string, the solar cell string being formed by connecting a plurality of solar cells as described above.

According to the solar cell, the method for manufacturing the same, and the photovoltaic module, in the method of the present application, the doped layer can provide sufficient dopant to effectively fill grain boundary defects in the initial intrinsic material layer, and the doping concentration required for the doped passivation layer can be flexibly adjusted by changing the doping concentration of the doped layer, thereby achieving a better field passivation effect. Compared with in-situ doping, due to a non-conductive characteristic of an intrinsic material, the non-conductive intrinsic material may not cause short-circuit problems in electrodes of a graphite boat in a film-forming device during the deposition, thereby prolonging the service life of the graphite boat and reducing manufacturing costs. Moreover, the dopant enters the initial intrinsic material layer from the doped layer, and the diffusion process causes less damage to the tunnel layer and is less likely to cause defects in the tunnel layer, thereby allowing the tunnel layer to maintain good tunnelling efficiency and stability. In addition, the manufacturing method in the present application has a lower requirement for an annealing tube, the requirement for the manufacturing environment of the present application can be met only by providing a uniform temperature field without considering non-uniformity of doping caused by an uneven gas field, which allows for greater loading capacity and production capacity of a single-tube device. Therefore, the method for manufacturing the solar cell of the present application has good doping uniformity of the doped passivation layer and low manufacturing difficulty.

### BRIEF DESCRIPTION OF THE DRAWINGS

In order to more clearly illustrate the technical solutions in embodiments of the present application or the conventional art, the accompanying drawings used in the description of the embodiments or the conventional art will be briefly introduced below. It is apparent that, the accompanying drawings in the following description are only for some embodiments of the present application, and other drawings can be obtained by those of ordinary skill in the art from the provided drawings without creative efforts.
FIG. 1 is a flowchart I of a method for manufacturing a solar cell according to an embodiment.
FIG. 2 is a schematic view of a solar cell after step S310 according to the embodiment in FIG. 1.
FIG. 3 is a schematic view of a solar cell after step S410 according to the embodiment in FIG. 1.
FIG. 4 is a flowchart II of a method for manufacturing a solar cell according to an embodiment.
FIG. 5 is a schematic view of a solar cell after step S320 according to the embodiment in FIG. 4.
FIG. 6 is a schematic view of a solar cell after step S410 according to the embodiment in FIG. 4.
FIG. 7 is a flowchart III of a method for manufacturing a solar cell according to an embodiment.
FIG. 8 is a schematic view I of a solar cell with an inner expansion layer formed according to the embodiment in FIG. 7.
FIG. 9 is a schematic view II of a solar cell with an inner expansion layer formed according to the embodiment in FIG. 7.
FIG. 10 is a flowchart IV of a method for manufacturing a solar cell according to an embodiment.
FIG. 11 is a schematic structural view of a solar cell after step S330 according to the embodiment in FIG. 10.
FIG. 12 is a schematic structural view of a solar cell after step S430 according to the embodiment in FIG. 10.
FIG. 13 is a flowchart V of a method for manufacturing a solar cell according to an embodiment.
FIG. 14 is a schematic structural view I of a solar cell after step S600 according to the embodiment in FIG. 13.
FIG. 15 is a schematic structural view II of a solar cell after step S600 according to an embodiment.
FIG. 16 is a schematic structural view III of a solar cell after step S600 according to an embodiment.
FIG. 17 is a schematic structural view IV of a solar cell after step S600 according to an embodiment.

Illustration for reference signs:
semiconductor substrate: 100; tunnel layer: 200; initial intrinsic material layer: 310; doped passivation layer: 320; doped layer: 401; first doped layer: 410; second doped layer: 420; barrier layer: 402; buffer layer: 403; inner expansion layer: 500; dielectric layer: 600; first electrode: 700.

### DETAILED DESCRIPTION

To facilitate understanding of the present application, a more comprehensive description of the present application will be given below with reference to the relevant accompanying drawings. Some of the embodiments of the present application are illustrated in the drawings. However, the present application may be implemented in many different forms and is not limited to the embodiments described herein. Rather, these embodiments are provided to make the contents disclosed in the present application more thoroughly and comprehensive.

Unless defined otherwise, all technical and scientific terms used herein have the same meanings as would generally understood by those skilled in the technical field to which the present application belongs to. The terms used herein in the specification of the present application are for the purpose of describing specific embodiments only, and are not intended to limit the present application.

It should be understood that when an element or layer is referred to as being "on", "adjacent to", "connected to", or "coupled to" another element or layer, the element or layer may be directly on, adjacent to, connected to, or coupled to the another element or layer, or an intervening element or layer may be disposed therebetween. On the contrary, when an element is referred to as being "directly on", "directly adjacent to", "directly connected to", or "directly coupled to" another element or layer, no intervening element or layer may be disposed therebetween.

It should be understood that although terms such as first, second, and third may be used to describe various elements, components, regions, layers, doping types and/or portions, the elements, components, regions, layers, doping types and/or portions may not be limited to such terms. Such terms are used only to distinguish one element, component, region, layer, doping type, or portion from another element, component, region, layer, doping type, or portion. Thus, without departing from the teaching of the present application, a first element, component, region, layer, doping type, or portion as discussed below may be referred to as a second element, component, region, layer, doping type, or portion. For example, a first doping type may be referred to as a second doping type, and similarly, the second doping type may be referred to as the first doping type. The first doping type and the second doping type are different doping types. For example, the first doping type may be P-type and the second doping type may be N-type, or the first doping type may be N-type and the second doping type may be P-type.

Spatial relationship terms such as "under", "underneath", "below", "beneath", "over", and "above" may be used for illustrative purposes to describe a relationship between one element or feature and another element or feature illustrated in the figures. It should be understood that, in addition to the orientations illustrated in the figures, the spatial relationship terms are intended to further include different orientations of the device in use and operation. For example, if the device in the figures is flipped over, the element or feature described as being "below", "underneath" or "under" another element or feature may be oriented as being "on" the another element or feature. Thus, the exemplary terms "below" and "under" may include two orientations of above and below. In addition, the device may include additional orientations (e.g., may be rotated by 90-degree ion or otherwisely oriented), and thus spatial descriptors used herein may be interpreted accordingly.

In use, the singular forms of "a/an", "one", and "the" may also include plural forms, unless otherwise clearly specified by the context. It should be further understood that the terms "include/comprise" and/or "have" specify the presence of the features, integers, steps, operations, components, portions, or their combinations, but may not exclude the presence or addition of one or more of other features, integers, steps, operations, components, portions, or their combinations. In addition, in the specification, the term "and/or" may include any and all combinations of associated listed items.

Embodiments of the present application are described herein with reference to schematic cross-sectional views of ideal embodiments (and intermediate structures) of the present application. in this way, illustrated shape variations caused by, for example, manufacturing techniques and/or tolerances, may be expected. Thus, the embodiments of the present application may not be limited to the specific shapes of the regions illustrated herein, but may include shape deviations caused by, for example, the manufacturing techniques. For example, an implanted region illustrated as a rectangle, typically, has rounded or curved features and/or a gradient of implant concentration at its edges rather than a binary change from an implanted region to a non-implanted region. Likewise, a buried region formed by implantation may result in some implantation in the region between the buried region and a surface through which the implantation takes place. Thus, the region shown in the drawings is generally schematic, and the illustrated shape is not intended to show the actual shape of the region of the device, and is not intended to limit the scope of the present application.

Embodiments of the present application provide a method for manufacturing a solar cell. The manufacturing method according to the embodiments of the present application may include, but is not limited to, manufacturing a tunnel oxide passivated contact (TOPCon) solar cell or an interdigitated back contact (IBC) solar cell, to form a passivated contact structure in the solar cell as above. Taking the TOPCon solar cell as an example, the passivated contact structure has functions of surface passivation and selective collection of carriers, which can effectively improve efficiency and stability of the solar cell.

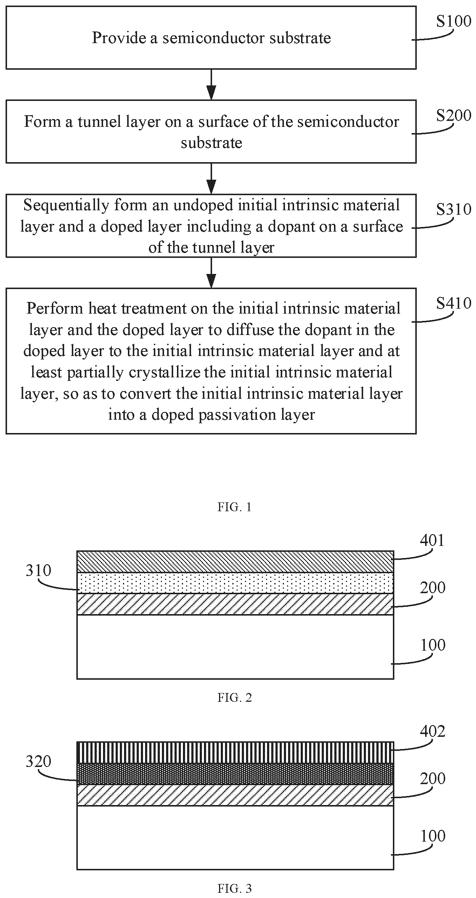

FIG. 1 is a flowchart I of a method for manufacturing a solar cell according to an embodiment, FIG. 2 is a schematic view of a solar cell after step S310 according to the embodiment in FIG. 1, and FIG. 3 is a schematic view of a solar cell after step S410 according to the embodiment in FIG. 1. Referring to FIG. 1 to FIG. 3, the method for manufacturing the solar cell includes step S100 to step S410.

At step S100, a semiconductor substrate 100 is provided.

The semiconductor substrate 100 may be a silicon substrate.

At step S200, a tunnel layer 200 is formed on a surface of the semiconductor substrate 100.

The tunnel layer 200 may also be referred to as a tunnel oxide layer or a surface passivation layer. The tunnel layer 200 may be made of a dielectric material. The dielectric material includes, but is not limited to, any one of silicon oxide, aluminum oxide, silicon nitride, silicon oxynitride, magnesium fluoride, amorphous silicon, polysilicon, silicon carbide, and titanium oxide.

Further, the tunnel layer 200 may be formed by using any one of the following processes: atomic layer deposition (ALD), plasma enhanced chemical vapor deposition (PECVD), and plasma enhanced atomic layer deposition (PEALD). Furthermore, the tunnel layer 200 may be formed by using one of the above processes at a lower reaction temperature, so that the tunnel layer 200 is formed at a reaction temperature below 600°C, thereby reducing damage to the material caused by high-temperature environments and making it easier to control thicknesses and uniformity of the tunnel layer 200, which is conducive to improving the quality of the formed layer. Exemplarily, the tunnel layer 200 made of silicon oxide may be manufactured by the PECVD process, in which a chamber temperature ranges from 300°C to 500°C, a process gas includes nitrous oxide, and under the action of a microwave power supply, oxygen ions from ionization combine with silicon to form silicon oxide.

At step S310, an undoped initial intrinsic material layer 310 and a doped layer 401 including a dopant are sequentially formed on a surface of the tunnel layer 200.

The dopant in the doped layer 401 may be either an N-type dopant or a P-type dopant. The N-type dopant includes, but is not limited to, phosphorus, arsenic, and the like. The P-type dopant includes, but is not limited to, boron, and the like. The initial intrinsic material layer 310 may be made of an intrinsic material. The intrinsic material may be, but is not limited to, any of intrinsic amorphous silicon, intrinsic microcrystalline silicon, and intrinsic polycrystalline silicon. It may be understood that the intrinsic material is not electrically conductive. Therefore, adhesion of the intrinsic material in a chamber of the process device may not cause short circuit problems irrespective of the use of either process device to form the initial intrinsic material layer 310, thereby improving the service life and reliability of the process device.

At step S410, heat treatment is performed on the initial intrinsic material layer 310 and the doped layer 401 to diffuse the dopant in the doped layer 401 to the initial intrinsic material layer 310 and at least partially crystallize the initial intrinsic material layer 310, so as to convert the initial intrinsic material layer 310 into a doped passivation layer 320.

The doped layer 401 after heat treatment is then converted into a barrier layer 402 without any dopant. The tunnel layer 200 and the doped passivation layer 320 together form a passivated contact structure. The passivated contact structure allows majority carriers (electrons) to smoothly pass through the tunnel layer 200 by means of a tunnel effect, and blocks recombinations of minority carriers (holes), thereby reducing density of interface states, increasing an open-circuit voltage and a fill factor of the solar cell, and improving performance of the solar cell. Specifically, heat treatment can promote the movement of atoms such as phosphorus and boron in the doped layer 401 towards the initial intrinsic material layer 310, thereby achieving doping of the initial intrinsic material layer 310.

A crystallization rate after heat treatment may be greater than 60%, or even reach 90% to 93%. Specifically, a higher degree of crystallization of the intrinsic material may be realized through heat treatment, which can help to reduce a disordered structure in the material, thereby reducing destiny of defect states of the doped passivation layer 320. It may be understood that the defect states generally serve as carrier recombination centers, capturing electrons and holes, and leading to recombinations and disappearance of the electrons and the holes. Therefore, when the destiny of the defect states is higher, an increased number of recombination centers may reduce the lifetime and mobility of carriers, thereby affecting electrical properties of the material. Therefore, the initial intrinsic material layer 310 is crystallized by heat treatment to reduce the density of the defect states, which can help to achieve higher-concentration effective doping and provide a better field passivation effect, thereby improving efficiency and stability of the solar cell.

Further, the temperature of the heat treatment is positively related to the thickness of the initial intrinsic material layer 310 and the thickness of the doped layer 401, and the time of the heat treatment is positively related to the thickness of the initial intrinsic material layer 310 and the thickness of the doped layer 401. As long as the dopant can diffuse uniformly from the doped layer 401 to the initial intrinsic material layer 310, the specific time and temperature of the heat treatment are not limited in this embodiment.

In an embodiment of the present application, the doped layer 401 can provide sufficient dopant to effectively fill grain boundary defects in the initial intrinsic material layer 310. The doping concentration required for the doped passivation layer 320 can be flexibly adjusted by changing the doping concentration of the doped layer 401, thereby achieving a better field passivation effect. Compared with in-situ doping, due to a non-conductive characteristic of an intrinsic material, the non-conductive intrinsic material may not cause short-circuit problems in electrodes of a graphite boat in a film-forming device during the deposition, thereby prolonging the service life of the graphite boat and reducing manufacturing costs. Moreover, the dopant enters the initial intrinsic material layer 310 from the doped layer 401, and the diffusion process causes less damage to the tunnel layer 200 and is less likely to cause defects in the tunnel layer 200, thereby allowing the tunnel layer 200 to maintain good tunnelling efficiency and stability. In addition, the manufacturing method in the present application has a lower requirement for an annealing tube, the requirement for the manufacturing environment of the present application can be met only by providing a uniform temperature field without considering non-uniformity of doping caused by an uneven gas field, which allows for greater loading capacity and production capacity of a single-tube device. Therefore, the method for manufacturing the solar cell provided by the present application has good doping uniformity of the doped passivation layer 320 and low manufacturing difficulty.

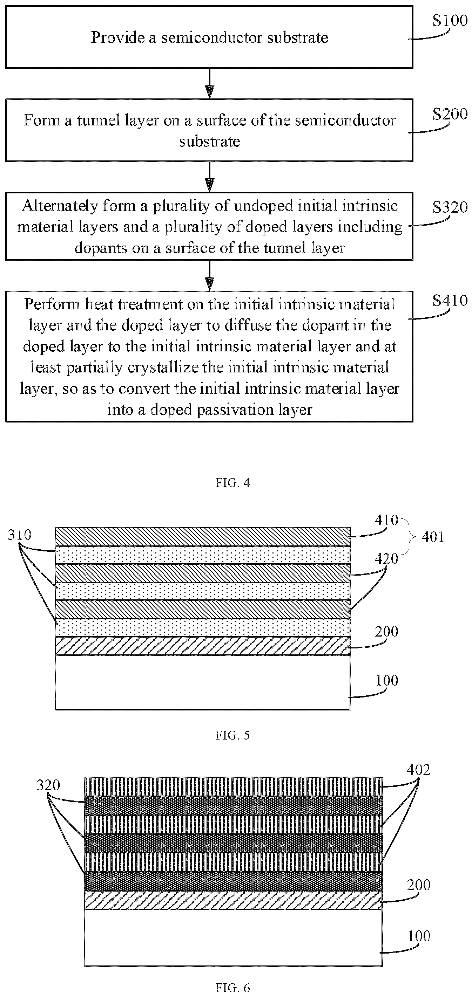

FIG. 4 is a flowchart II of a method for manufacturing a solar cell according to an embodiment, FIG. 5 is a schematic view of a solar cell after step S320 according to the embodiment in FIG. 4, and FIG. 6 is a schematic view of a solar cell after step S410 according to the embodiment in FIG. 4. Referring to FIG. 4 to FIG. 6, in an embodiment, the method for manufacturing the solar cell includes step S100 to step S410. For steps S100, S200, and S410, reference may be made to the foregoing embodiments, which will not be repeatedly described herein again. The step of sequentially forming the undoped initial intrinsic material layer 310 and the doped layer 401 including the dopant on the surface of the tunnel layer 200 includes step S320 of this embodiment.

At step S100, a semiconductor substrate 100 is provided.

At step S200, a tunnel layer 200 is formed on a surface of the semiconductor substrate 100.

At step S320, a plurality of undoped initial intrinsic material layers 310 and a plurality of doped layers 401 including dopants are alternately formed on the surface of the tunnel layer 200.

Doping concentration of the plurality of doped layers 401 may be different and may be determined according to factors such as the thicknesses of the doped layers 401 and the number of initial intrinsic material layers 310 adjacent to the doped layers 401. For example, dopants with the same doping dose may be provided in different doped layers 401, and the doped layer 401 with a larger thickness has lower doping concentration. In another example, if the doped layer 401 is arranged adjacent to two initial intrinsic material layers 310, the doped layer 401 may be disposed to have higher doping concentration. If the doped layer 401 is arranged adjacent to only one initial intrinsic material layer 310, the doped layer 401 may be disposed to have lower doping concentration.

Optionally, the number of the initial intrinsic material layer 310 and the number of the doped layer 401 may be the same, the layer closest to the tunnel layer 200 is the initial intrinsic material layer 310, and the layer farthest from the tunnel layer 200 is the doped layer 401. For example, as shown in FIG. 5, three initial intrinsic material layers 310 and three doped layers 401 may be provided, and the initial intrinsic material layer 310, the doped layer 401, the initial intrinsic material layer 310, the doped layer 401, the initial intrinsic material layer 310, and the doped layer 401 are alternately stacked on the surface of the tunnel layer 200. The number of the initial intrinsic material layer 310 and the number of the doped layer 401 may alternatively be different, and the layer closest to the tunnel layer 200 and the film layer farthest from the tunnel layer 200 are both the initial intrinsic material layer 310. For example, the initial intrinsic material layer 310, the doped layer 401, the initial intrinsic material layer 310, the doped layer 401, and the initial intrinsic material layer 310 may be alternately stacked on the surface of the tunnel layer 200. That is, the specific numbers and the stacking manners of the initial intrinsic material layers 310 and the doped layers 401 are not limited in this embodiment.

At step S410, heat treatment is performed on the initial intrinsic material layer 310 and the doped layer 401 to diffuse the dopant in the doped layer 401 to the initial intrinsic material layer 310, so as to convert the initial intrinsic material layer 310 into a doped passivation layer 320.

In an embodiment of the present application, on the premise that the total thickness of the plurality of initial intrinsic material layers 310 is the same as or similar to the thickness of the initial intrinsic material layers 310 in the related art, by stacking the plurality of initial intrinsic material layers 310 and the plurality of doped layers 401, the thickness of a single initial intrinsic material layer 310 can be effectively reduced, thereby preventing the problem of impossible uniform diffusion of the dopant caused by an excessive thickness, and then preventing a situation where the final formed initial intrinsic material layer 310 has high doping concentration on a side adjacent to the doped layer 401 and low doping concentration on a side adjacent to the semiconductor substrate 100, resulting in uneven and poor diffusion of the dopant. Moreover, the doped layer 401 is arranged between adjacent initial intrinsic material layers 310, and after the doped layer 401 is converted into a barrier layer 402 during the heat treatment, it is also possible to reduce an influence of metallization ablation on the solar cell without easily burning through to the semiconductor substrate 100, thereby enabling a thinner doped passivation layer 320. For example, the doped passivation layer 320 is a poly layer. In this case, if the poly layer is excessively thick, absorption of parasitic light can be increased, and short-circuit current density of solar cell can be reduced, thereby affecting overall power conversion efficiency of the device. However, by using a thinner poly layer, such absorption of parasitic light can be reduced, allowing more photons to reach an active layer and be effectively absorbed, thereby improving long-wavelength response.

In an embodiment, a thickness of a second doped layer 420 is greater than a thickness of a first doped layer 410. The first doped layer 410 is one of the plurality of doped layers 401 that is furthest from the semiconductor substrate 100, and the second doped layer 420 is another doped layer 401 except the first doped layer 410. The first doped layer 410 has a thickness ranging from 5 nm to 30 nm. Exemplarily, the thickness of the first doped layer 410 may be 5 nm, 10 nm, 20 nm, 25 nm, or 30 nm. The second doped layer 420 has a thickness ranging from 1 nm to 10 nm. Exemplarily, the thickness of the second doped layer 420 may be 1 nm, 3 nm, 5 nm, 8 nm, or 10 nm. In an embodiment of the present application, through setting the thickness of the doped layer 401 as above, a sufficient amount of doping can be provided to the initial intrinsic material layer 310, and the influence of metallization ablation on the solar cell can be effectively reduced.

In an embodiment, if the thickness of the first doped layer 410 is less than 10 nm, for example, may be 5 nm or 7 nm, the method further includes: forming a mask layer on a surface of the first doped layer 410. The sum of the thickness of the mask layer and the thickness of the first doped layer 410 is greater than 20 nm. Specifically, the formation of the first doped layer 410 requires participation of PH₃, which is used to achieve doping, and the cost of PH3 is high. Therefore, a thinner first doped layer 410 is used in this embodiment, which can effectively save the amount of the used PH₃ and reduce process costs. It may be understood that in some cases, the semiconductor substrate 100 may have undesired coating on a front surface, and the method for manufacturing the solar cell further correspondingly requires a wet etching step to remove the undesired coating. Then, the first doped layer 410 is also used to protect the doped passivation layer 320, the tunnel layer 200 and the like between the first doped layer 410 and the semiconductor substrate 100 during wet etching, so as to reduce an influence of an etching liquid on the performance of the solar cell. However, if the thickness of the first doped layer 410 is less than 10 nm, it cannot completely resist erosion of the etching liquid, thereby causing damage to the layers such as the doped passivation layer 320. Therefore, by additionally provide the mask layer and making the sum of the thicknesses of the mask layer and the first doped layer 410 greater than 20 nm, the layers such as the doped passivation layer 320 can be better protected during the wet etching, so as to improve the performance of the solar cell.

In an embodiment, the mask layer is made of an undoped silicon compound, for example, undoped silicon oxide. Specifically, in the case that the mask layer is made of undoped silicon oxide and the first doped layer 410 is made of dopant-containing silicon oxide, after the heat treatment, the barrier layer 402 formed by conversion of the mask layer and the barrier layer 402 formed by conversion of the first doped layer 410 including the dopant can be removed through the same process flow, thereby simplifying the process flow. It may be understood that in some embodiments, the mask layer may alternatively be made of other materials that can resist the etching liquid, which is not limited herein.

In an embodiment, a thickness of the first doped layer 410 is greater than a thickness of the tunnel layer 200, and a thickness of the second doped layer 420 is greater than or equal to the thickness of the tunnel layer 200. If the thickness of the tunnel layer 200 is thinner, the tunnel resistance may be significantly reduced, allowing electrons to more easily pass through a potential barrier, thereby improving conductivity. However, the doped layer 401 is used to provide the dopant for the initial intrinsic material layer 310 to achieve sufficient and uniform doping of the initial intrinsic material layer 310. Moreover, the doped layer 401 is further used to protect the substrate during metallization ablation. Therefore, a thicker doped layer 401 is required to meet a manufacturing requirement for the solar cell. Further, the thickness of the tunnel layer 200 ranges from 0.5 nm to 2 nm, for example, may be 0.5 nm, 1 nm, 1.5 nm, or 2 nm.

In an embodiment, the doped layer 401 and the tunnel layer 200 are both made of silicon oxide compounds, and a silicon-to-oxygen ratio of the second doped layer 420 is greater than or equal to a silicon-to-oxygen ratio of the first doped layer 410 and the tunnel layer 200. Specifically, a lower silicon-to-oxygen ratio can reduce a tunnel barrier of the tunnel layer 200, thereby improving tunnelling efficiency of electrons. Moreover, an appropriate silicon-to-oxygen ratio can optimize passivation characteristics and further improve the performance of the device. However, for the doped layer 401, the percentage of silicon content in the doped layer 401 is positively related to the amount of dopant that can be doped. Therefore, increasing the silicon-to-oxygen ratio of the second doped layer 420 can increase the amount of dopant, thereby enabling sufficient doping of the initial intrinsic material layer 310. Further, the silicon-to-oxygen ratio of the doped layer 401 is greater than 1:2, for example, 1:2 or 1:1. The silicon-to-oxygen ratio of the tunnel layer 200 is less than 1:1.5, for example, 1:1.5, 1:1.8, or 1:2.

In an embodiment, the doping concentration of the second doped layer 420 is greater than the doping concentration of the first doped layer 410. The first doped layer 410 is one of the plurality of doped layers 401 that is furthest from the semiconductor substrate 100; and the second doped layer 420 is another doped layer 401 except the first doped layer 410. For example, the doped layer 401 includes silicon oxide doped with a dopant. If the doping concentration of the doped layer 401 is lower, the oxygen content in the doped layer 401 is lower, and correspondingly, the silicon content in the doped layer 401 is higher. It may be understood that if the oxygen content in the doped layer 401 is lower, it is more difficult to remove the doped layer 401. Therefore, by setting that the doping concentration of the second doped layer 420 is greater than the doping concentration of the first doped layer 410, the barrier layer 402 formed by conversion of the first doped layer 410 during the heat treatment can be easily removed on the premise of providing a sufficient amount of doping, so as to meet a structural design requirement for the solar cell.

In an embodiment, the initial intrinsic material layer 310 has a single-layer thickness ranging from 2 nm to 150 nm. Exemplarily, the thickness of the initial intrinsic material layer 310 may be 2 nm, 5 nm, 10 nm, 20 nm, 30 nm, 40 nm, 50 nm, 100 nm, or 150 nm. The thickness of each initial intrinsic material layer 310 may be determined according to the total thickness and the number of the doped passivation layers 320 required in the solar cell, to provide a better passivation effect.

In an embodiment, the method further includes: subsequent to performing heat treatment on the initial intrinsic material layer 310 and the doped layer 401, removing the barrier layer 402 formed by conversion of the first doped layer 410 during heat treatment. The first doped layer 410 is one of the plurality of doped layers 401 that is furthest from the semiconductor substrate 100. Specifically, the barrier layer 402 formed by conversion of the first doped layer 410 made of a material such as silicon oxide may be removed by using any one of hydrofluoric acid (HF), hydrochloric acid (HCl), and the like. It is to be noted that, in some embodiments, if the barrier layer 402 formed by conversion of the first doped layer 410 has a smaller thickness, or is more difficult to be removed, and the effect on deterioration of the performance of the solar cell is small, the barrier layer 402 formed by conversion of the first doped layer 410 during heat treatment may not be removed.

In an embodiment, forming the plurality of undoped initial intrinsic material layers 310 and the plurality of doped layers 401 including dopants on the surface of the tunnel layer 200 includes: forming the initial intrinsic material layer 310 and the doped layer 401 on the surface of the tunnel layer 200 in a same PECVD device.

Specifically, the deposition rate of the initial intrinsic material layer 310 and the deposition rate of the doped layer 401 range from 2 nm/min to 20 nm/min. Exemplarily, the deposition rate may be 2 nm/min, 3 nm/min, 5 nm/min, 8 nm/min, 10 nm/min, 14 nm/min, 16 nm/min, 19 nm/min, or 20 nm/min. Further, the deposition rate may be between 3 nm/min and 10 nm/min. By setting the deposition rate within the above range, on the one hand, the formation quality of the initial intrinsic material layer 310 can be ensured, and on the other hand, it is also conducive to increasing a production capacity of the solar cell. When the initial intrinsic material layer 310 and the doped layer 401 are deposited, chamber temperatures of the PECVD process may be the same and range from 200°C to 700°C. Exemplarily, the chamber temperature may be 350°C, 380°C, 401°C, 410°C, 430°C, 450°C, 470°C, or 480°C. Furthermore, the chamber temperature may range from 350°C to 480°C. By setting the chamber temperature within the above range, the deposition rate of the initial intrinsic material layer 310 may be within a controllable range, thereby making uniformity of the initial intrinsic material layer 310 better. Moreover, after the initial intrinsic material layer 310 and the doped layer 401 are formed by the above method, there is no need to cool down a furnace tube, and an initial contact structure can continue to be heat treated in the same tube to convert the initial intrinsic material layer 310 into the doped passivation layer 320, thereby improving manufacturing efficiency.

In embodiments of the present application, the plurality of initial intrinsic material layers 310 and the plurality of doped layers 401 are completed in the same PECVD device, thereby effectively improving deposition efficiency and reducing manufacturing costs. Moreover, compared with in-situ doping, since the initial intrinsic material layer 310 is made of a non-conductive intrinsic material, the non-conductive intrinsic material may not cause short-circuit problems in electrodes of a graphite boat in the PECVD device during the deposition, thereby prolonging the service life of the graphite boat and reducing manufacturing costs. Compared with in-situ doping, the process gas composition in the embodiments of the present application is simpler, which can make uniformity of the thickness of the initial intrinsic material layer 310 better and the deposition rate faster, helping to increase a production capacity.

Specifically, the process gases in the PECVD process include a silicon source gas and a diluent gas. The silicon source gas may be excited and ionized to generate plasma, and then the layer is deposited. The silicon source gas includes at least one of SiH₄, Si₂H₆, SiCl₃H, and SiH₂Cl₂. The diluent gas can, on the one hand, maintain pressure in the tube, and on the other hand, can also dilute the silicon source gas to improve uniformity of distribution of the silicon source gas. The diluent gas includes at least one of H₂, Ar, N₂, He, and Xe. It is to be noted that inert gases such as Ar, N₂, He, and Xe can dilute the silicon source gas to improve uniformity and maintain the pressure in the tube. H₂ can dilute the silicon source gas to improve uniformity and maintain the pressure in the tube, and can also be ionized to provide hydrogen ions to improve passivation. For example, a reaction gas for forming the initial intrinsic material layer 310 may include SiH₄ and H₂, and a reaction gas for forming the doped layer 401 may include SiH₄, N₂O, and H₂ as well as PH₃ used to achieve doping. In some embodiments, the diluent gas includes a mixture of H₂ and Ar.

Optionally, a ratio of a flow rate of the diluent gas to a flow rate of the silicon source gas is greater than or equal to 1.5. The ratio of the flow rate of the diluent gas to the flow rate of the silicon source gas ranges from 1.5 to 4. Exemplarily, the ratio of the flow rate of the diluent gas to the flow rate of the silicon source gas may be 1.5:1, 2:1, 3:1, or 4:1. By setting the ratio of the flow rate of the diluent gas to the flow rate of the silicon source gas within the above range, uniformity of the layer thickness can be better. It is to be noted that gas flow rates of the diluent gas and the silicon source gas are related to a size of the reactor tube. The gas flow rates of the diluent gas and the silicon source gas are not limited in the embodiments of the present application.

In an embodiment, the doping concentration of the doped layer 401 is greater than 1e21 atoms/cm³. Exemplarily, the doping concentration of the doped layer 401 is 1e21 atoms/cm³, 2e21 atoms/cm³, 5e21 atoms/cm³, or 1e22 atoms/cm³. It may be understood that if the doping concentration of the doped layer 401 is higher, the doped layer 401 can provide more dopant atoms for the initial intrinsic material layer 310, so that the doping concentration of the doped layer 401 is positively related to the doping concentration of the doped passivation layer 320 formed after diffusion. As the doping concentration increases, the doped passivation layer 320 can form a stronger field effect, thereby enhancing a capability to block carriers (especially minority carriers) and reducing a surface recombination rate. Moreover, the high doping concentration can result in formation of a lower barrier height at an interface, making it easier for electrons to pass through an interface between a metal electrode and the doped passivation layer 320, thereby helping to reduce contact resistance between the metal electrode and the doped passivation layer 320. In the embodiments of the present application, by providing the doped layer 401 with higher doping concentration, the doping concentration of the doped passivation layer 320 finally formed can be effectively increased, thereby improving conversion efficiency and performance of the solar cell.

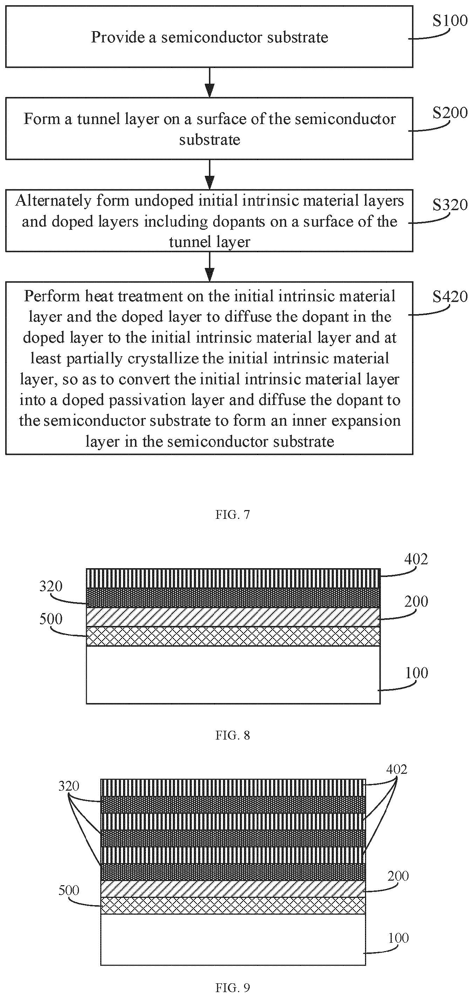

In an embodiment, referring to FIG. 7, the heat treatment is further used to diffuse the dopant into the semiconductor substrate 100 to form an inner expansion layer 500 in the semiconductor substrate 100. FIG. 8 is a schematic view I of the solar cell formed with the inner expansion layer 500 according to the embodiment in FIG. 7, and FIG. 9 is a schematic view II of the solar cell formed with the inner expansion layer 500 according to the embodiment in FIG. 7. Referring to FIG. 8 and FIG. 9, the dopant atoms can pass through the tunnel layer 200 and enter the semiconductor substrate 100 from the front surface or back surface of the semiconductor substrate 100, thereby converting the semiconductor substrate 100 with a certain thickness into the inner expansion layer 500. A doping type of the inner expansion layer 500 may be the same as that of the semiconductor substrate 100, or may be different from that of the semiconductor substrate 100. Specifically, the inner expansion layer 500 may improve a carrier collection effect of the solar cell. Further, the doping concentration of the inner expansion layer 500 may be greater than 1e21 atoms/cm³ to have a better carrier collection effect.

In an embodiment, the inner expansion layer 500 has a thickness ranging from 0.02 µm to 1 µm. Exemplarily, the thickness of the inner expansion layer 500 may be 0.02um, 0.05 µm, 0.1 µm, 0.2 µm, 0.5 µm, or 1 µm. It may be understood that a greater thickness of the inner expansion layer 500 means that more dopants are required to enter the semiconductor substrate 100 through the tunnel layer 200, thereby causing greater damage to the tunnel layer 200 and affecting the surface passivation effect of the passivated contact structure on the solar cell. Moreover, an excessively thick inner expansion layer 500 may also produce a recombination center of carriers, which can capture electrons and holes, and cause auger recombination and disappearance of the electrons and holes, thereby reducing the lifetime and mobility of the carriers and affecting electrical properties of the solar cell. Therefore, the carrier collection effect and the surface passivation effect of the solar cell can be balanced by reasonably adjusting the thickness of the inner expansion layer 500.

In an embodiment, conditions of the heat treatment include a heat treatment temperature greater than 800°C and a heat treatment time greater than 20 min. In the embodiments of the present application, by setting the heat treatment temperature and the heat treatment time within the above ranges, on the one hand, it is conducive to enabling higher-concentration effective doping of the initial intrinsic material layer 310, and on the other hand, it is conducive to facilitating the dopant atoms to enter the substrate to form the inner expansion layer 500.

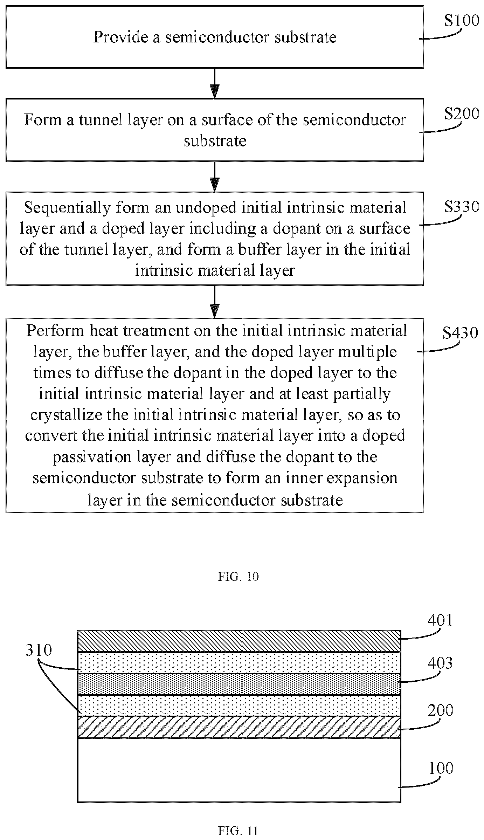

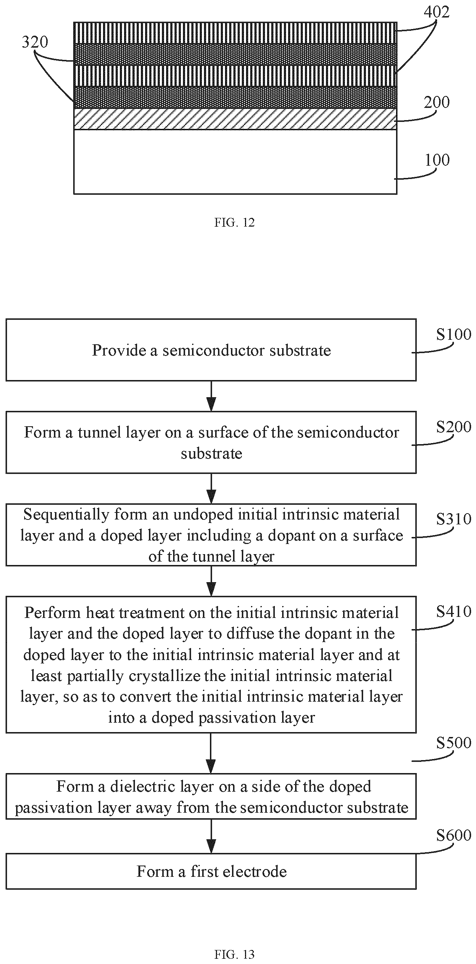

FIG. 10 is a flowchart IV of a method for manufacturing a solar cell according to an embodiment, FIG. 11 is a schematic structural view of a solar cell after step S330 according to the embodiment in FIG. 10, and FIG. 12 is a schematic structural view of a solar cell after step S430 according to the embodiment in FIG. 10. Referring to FIG. 10 to FIG. 12, in an embodiment, the method for manufacturing the solar cell includes step S100 to step S430. For step S100 and step S200, reference may be made to the foregoing embodiments, which will not be repeatedly described herein again.

At step S100, a semiconductor substrate 100 is provided.

At step S200, a tunnel layer 200 is formed on a surface of the semiconductor substrate 100.

At step S330, an undoped initial intrinsic material layer 310 and a doped layer 401 including a dopant are sequentially formed on a surface of the tunnel layer 200; and a buffer layer 403 is formed in the initial intrinsic material layer 310.

The buffer layer 403 includes an undoped silicon compound. The buffer layer 403 may be understood as dividing the initial intrinsic material layer 310 into two layers. That is, step S330 includes sequentially forming one layer of the undoped initial intrinsic material layer 310, the buffer layer 403, another layer of initial intrinsic material layer 310, and the doped layer 401 including the dopant on the surface of the tunnel layer 200. The buffer layer 403 may be made of the same material as the tunnel layer 200, for example, made of a silicon compound such as undoped silicon oxide. A thickness of the buffer layer 403 may be the same as or similar to the thickness of the tunnel layer 200, which may specifically range from 0.5 nm to 2 nm. Exemplarily, the thickness of the buffer layer 403 may be 0.5 nm, 1 nm, 1.5 nm, or 2 nm.

At step S430, heat treatment is performed on the initial intrinsic material layer 310, the buffer layer 403, and the doped layer 401.

The heat treatment includes a plurality of treatment stages, and temperatures in the plurality of treatment stages are not exactly the same. After the plurality of treatment stages, the dopant in the doped layer 401 is diffused respectively to the initial intrinsic material layers 310, so that the initial intrinsic material layer 310 is at least partially crystallized, such that the initial intrinsic material layer 310 is converted into a doped passivation layer 320. In addition, the doped layer 401 and the buffer layer 403 are both converted into barrier layers 402.

In the embodiments of the present application, by providing the buffer layer 403 and performing multi-stage heat treatment, the dopant can sequentially enter one layer of the initial intrinsic material layer 310, the buffer layer 403, and another layer of the initial intrinsic material layer 310 in a direction approaching the substrate during the diffusion of the heat treatment. Therefore, the dopant may be relatively uniformly distributed in the buffer layer 403, and then enter the initial intrinsic material layer 310 on a side of the buffer layer 403 adjacent to the semiconductor substrate 100, thereby improving uniformity of distribution of the dopant in the doped passivation layer 320, that is, improving uniformity of doping of the doped passivation layer 320 finally formed. Moreover, by making the distribution of the dopant more uniform, a situation where an excessive dopant in a certain region causes increased damage to the corresponding tunnel layer 200 caused by the dopant in this region during the heat treatment, thereby improving the performance of the tunnel layer 200 and improving the surface passivation effect of the passivated contact structure on the solar cell.

In an embodiment, the heat treatment includes a first treatment stage and a second treatment stage performed sequentially. In the first treatment stage, the dopant reaches the vicinity of the buffer layer 403, only a small amount or even no dopant enters the initial intrinsic material layer 310 on the side of the buffer layer 403 adjacent to the semiconductor substrate 100, so that the dopant in the buffer layer 403 is first homogenized in the buffer layer 403. In the second treatment stage, the homogenized dopant further enters the initial intrinsic material layer 310 on the side of the buffer layer 403 adjacent to the semiconductor substrate 100, thereby achieving doping of all the initial intrinsic material layers 310. A temperature in the second treatment stage is greater than a temperature in the first treatment stage. Exemplarily, the temperature in the first treatment stage ranges from 800°C to 910°C, for example, may be 800°C, 850°C, 900°C, or 910°C. Exemplarily, the temperature in the second treatment stage ranges from 900°C to 1000°C, for example, may be 900° C, 910° C, 950° C, or 1000°C. Specifically, the first treatment stage is performed at a lower temperature, and then the temperature is increased to perform the second treatment stage, so that a doping speed and efficiency of the manufacturing method can be further improved. Moreover, by increasing the temperature during the heat treatment, the initial intrinsic material layer 310 can also be crystallized to a higher degree, thereby further reducing the density of the defect states of the doped passivation layer 320. It may be understood that the inner expansion layer 500 may be formed in the semiconductor substrate 100 during the second treatment stage. It is to be noted that the time and temperatures in the two treatment stages are correlated with each other, and as long as it is satisfied that the dopant reaches the vicinity of the buffer layer 403 after the first treatment stage and the doping of all the initial intrinsic material layers 310 is completed after the second treatment stage, it falls within the protection scope of this embodiment, which are not limited herein.

In an embodiment, the heat treatment includes a first treatment stage and a second treatment stage performed sequentially. In the first treatment stage, the dopant reaches the vicinity of the buffer layer 403, only a small amount or even no dopant enters the initial intrinsic material layer 310 on the side of the buffer layer 403 adjacent to the semiconductor substrate 100, so that the dopant in the buffer layer 403 is first homogenized in the buffer layer 403. In the second treatment stage, the homogenized dopant further enters the initial intrinsic material layer 310 on the side of the buffer layer 403 adjacent to the semiconductor substrate 100, thereby enabling the doping of all the initial intrinsic material layers 310. The temperature in the second treatment stage is less than the temperature in the first treatment stage. Exemplarily, the temperature in the first treatment stage ranges from 900°C to 1000°C, for example, may be 900° C, 910° C, 950° C, or 1000°C. The temperature in the second treatment stage ranges from 800°C to 910°C, for example, may be 800° C, 850° C, 900° C, or 910°C. Specifically, firstly, the first treatment stage is performed at a higher temperature, which enables the initial intrinsic material layer 310 to be crystallized to a higher degree, thereby reducing the density of the defect states of the doped passivation layer 320, and increasing effective doping concentration. Then, the second treatment stage is performed at a lower temperature, it is possible to achieve more accurate control over a diffusion depth by low-temperature drive-in, so that the inner expansion layer 500 can have a desired thickness, and the damage to the tunnel layer 200 can be reduced when the inner expansion layer 500 is formed in the semiconductor substrate 100. Further, compared with the case where the temperature in the second treatment stage is greater than the temperature in the first treatment stage, in this embodiment, the thickness of the buffer layer 403 is appropriately increased, which can reduce the amount of the dopant penetrating through the buffer layer 403 during the first treatment stage at a high temperature, thereby achieving a better dopant homogenization effect of the buffer layer 403 in the first treatment stage.

In an embodiment, the heat treatment includes a first treatment stage, a second treatment stage, and a third treatment stage that are performed sequentially. A temperature in the second treatment stage is greater than a temperature in the first treatment stage and is greater than a temperature in the third treatment stage. Specifically, by setting more treatment stages, multiple key indexes such as doping uniformity, a doping depth, and a crystallization rate can be better balanced, thereby improving the performance of the solar cell. It may be understood that in some embodiments, the heat treatment may alternatively include more treatment stages, which is not limited herein. In addition, in some embodiments, in the absence of the buffer layer, the multi-stage heat treatments can also be used to improve the above key indexes of the solar cell. For specific temperature setting at different stages, reference may be made to the foregoing embodiments, which will not be repeatedly described herein again.

In an embodiment, in the case that a plurality of initial intrinsic material layers 310 are provided, forming the buffer layer 403 in the initial intrinsic material layer 310 includes: forming the buffer layer 403 in one of the initial intrinsic material layers 310 that is closest to the semiconductor substrate 100. Specifically, the phenomenon of uneven doping is more obvious if it is closer to the semiconductor substrate 100. Therefore, forming the buffer layer 403 in the one of the initial intrinsic material layers 310 that is closest to the semiconductor substrate 100 can improve uniformity of doping of the doped passivation layer 320 adjacent to the semiconductor substrate 100, and reduce damage to the corresponding region in the tunnel layer 200 caused by the unevenly distributed dopant.

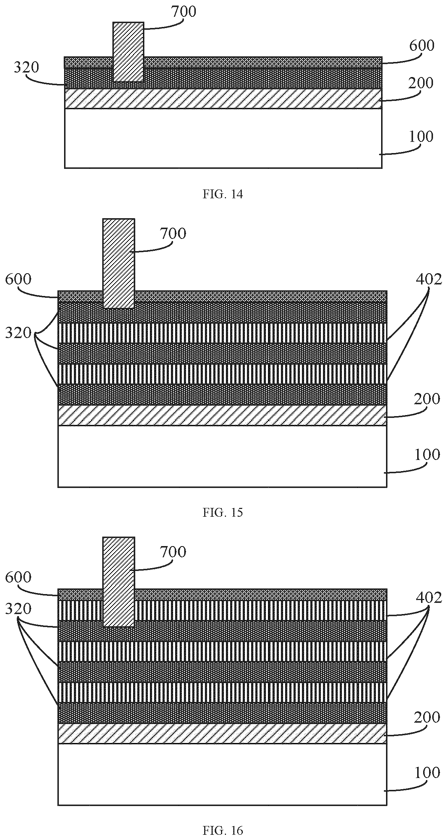

FIG. 13 is a flowchart V of a method for manufacturing a solar cell according to an embodiment, and FIG. 14 is a schematic structural view I of a solar cell after step S600 according to the embodiment in FIG. 13. Referring to FIG. 13 and FIG. 14, in an embodiment, the method for manufacturing the solar cell includes step S100 to step S600. For step S100 and step S410, reference may be made to the foregoing embodiments, which will not be repeatedly described herein again. It is to be noted that the description herein is only based on an example in which the initial intrinsic material layer 310 and the doped layer 401 are single-layered. In some embodiments, the initial intrinsic material layer 310 and the doped layer 401 are multi-layered, and the buffer layer 403 may be formed in the initial intrinsic material layer 310.

At S100, a semiconductor substrate 100 is provided.

At S200, a tunnel layer 200 is formed on a surface of the semiconductor substrate 100.

At S300, an undoped initial intrinsic material layer 310 and a doped layer 401 including a dopant are sequentially formed on a surface of the tunnel layer 200.

At S410, heat treatment is performed on the initial intrinsic material layer 310 and the doped layer 401 to diffuse the dopant in the doped layer 401 to the initial intrinsic material layer 310, so as to convert the initial intrinsic material layer 310 into a doped passivation layer 320.

At S500, a dielectric layer 600 is formed on a side of the doped passivation layer 320 away from the semiconductor substrate 100.

The dielectric layer 600 may be made of a dielectric material. The dielectric material includes, but is not limited to, at least one of silicon oxide, aluminum oxide, silicon nitride, silicon oxynitride, magnesium fluoride, amorphous silicon, polysilicon, silicon carbide, and titanium oxide. It may be understood that the dielectric layer 600 may be manufactured by using a process such as ALD, PECVD, or PEALD, which is not limited herein. In addition, during the formation of the dielectric layer 600, the barrier layer 402 at the top may be removed first to form the structure shown in FIG. 14.

At S600, a first electrode 700 is formed.

A first end of the first electrode 700 extends through the dielectric layer 600 and is electrically connected to the doped passivation layer 320, and a second end of the first electrode 700 extends in a direction away from the semiconductor substrate 100. Exemplarily, the first electrode 700 may be formed by screen printing and sintering, or the first electrode 700 may be formed by laser layer-cutting and electroplating, which is not limited herein.

In an embodiment, when the method for manufacturing the solar cell further includes a step of alternately forming a plurality of undoped initial intrinsic material layers 310 and a plurality of doped layers 401 including dopants on the surface of the tunnel layer 200 or a step of forming a buffer layer 403 in the initial intrinsic material layer 310, the solar cell may include a plurality of doped passivation layers 320 and a plurality of barrier layers 402. For example, FIG. 15 is a schematic structural view II of a solar cell after step S600 according to an embodiment. Referring to FIG. 15, the solar cell includes three doped passivation layers 320 and two barrier layers 402. The two barrier layers 402 may be formed by conversion of the doped layer 401. Alternatively, the barrier layer 402 away from the semiconductor substrate 100 may be formed by conversion of the doped layer 401, and the barrier layer 402 adjacent to the semiconductor substrate 100 may be formed by conversion of the buffer layer 403, which is not limited herein. In the case that the plurality of doped passivation layers 320 are provided, the first end of the first electrode 700 is electrically connected to any of the doped passivation layers 320 and extends through the dielectric layer 600 on a side of the doped passivation layer 320 electrically connected to the first electrode 700 away from the semiconductor substrate 100.

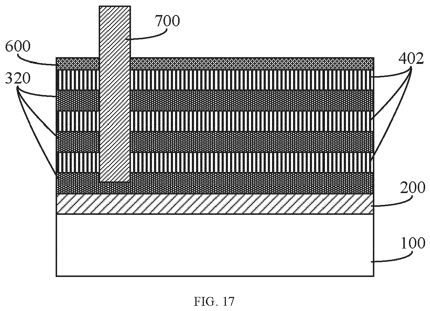

FIG. 16 is a schematic structural view III of a solar cell after step S600 according to an embodiment, and FIG. 17 is a schematic structural view IV of a solar cell after step S600 according to an embodiment. Referring to FIG. 16 and FIG. 17, the solar cell includes three doped passivation layers 320 and three barrier layers 402. The plurality of barrier layers 402 are formed by a method similar to that shown in FIG. 15, which is not repeatedly described herein again, except that the barrier layer 402 formed by conversion of the first doped layer 410 is not removed after the heat treatment. Further, the first electrode 700 may further extend through at least one of the barrier layers 402 as shown in FIG. 16, or further extend through at least one of the barrier layers 402 and at least one of the doped passivation layers 320 as shown in FIG. 17. Specifically, if a distance between the first end of the first electrode 700 and the semiconductor substrate 100 is smaller, a carrier transport path is shorter, resulting in better carrier transport performance. However, it may be understood that when the distance between the first end of the first electrode 700 and the semiconductor substrate 100 is smaller, a risk of burning through to the semiconductor substrate 100 is also higher during metallization ablation. In the embodiments of the present application, by providing the plurality of doped layers 401, protection can be provided in a metallization ablation stage, thereby reducing the risk of burning through to the semiconductor substrate 100. Furthermore, a depth of the first end of the first electrode 700 can be flexibly set as required, thereby expanding a process window and reducing process difficulty in the metallization ablation stage.

In an embodiment, the solar cell is a back contact (BC) solar cell. The BC solar cell is respectively provided with passivated contact structures of different doping types in different regions on the same side of the semiconductor substrate 100. Correspondingly, doped layers 401 including different types of dopants may be manufactured in different regions of the solar cell, respectively, and after all the initial intrinsic material layers 310 and the doped layers 401 are deposited, one heat treatment is performed, so that different types of doping are respectively performed on the initial intrinsic material layers 310 in the different regions to form the required solar cell.

It should be understood that, although the steps in the flowcharts are shown in sequence as indicated by the arrows, the steps are not necessarily performed in the order indicated by the arrows. Unless otherwise clearly specified herein, the steps are performed without any strict sequence limitation, and may be performed in other orders. In addition, at least some of the steps in the flowcharts may include a plurality of steps or a plurality of stages, and such steps or stages are not necessarily performed at a same moment, and may be performed at different moments. The steps or stages are not necessarily performed in sequence. The steps or stages and at least some of other steps, or steps or stages of other steps may be performed in turn or alternately.

Embodiments of the present application further provide a solar cell, manufactured by using the method for manufacturing the solar cell as described above.

Still referring to FIG. 14, the solar cell provided by the embodiments of the present application includes a semiconductor substrate 100, a tunnel layer 200, a doped passivation layer 320, a dielectric layer 600, and a first electrode 700. The tunnel layer 200 is located on a surface of the semiconductor substrate 100. The doped passivation layer 320 is stacked on a side of the tunnel layer 200 away from the semiconductor substrate 100. The dielectric layer 600 is arranged on a side of the doped passivation layer 320 away from the tunnel layer 200. A first end of the first electrode 700 is electrically connected to the doped passivation layer 320 and extends through the dielectric layer 600, and a second end of the first electrode 700 extends in a direction away from the semiconductor substrate 100. Further, the first electrode 700 may further extend into the doped passivation layer 320. It may be understood that the first electrode 700 has one end extending through the dielectric layer 600 and extends into the passivated contact structure, so that a connection area between the first electrode 700 and the passivated contact structure can be larger, and an electrical connection effect can be better. Furthermore, the solar cell further includes an emitter, an anti-reflection layer, and a second electrode. The emitter and the anti-reflection layer are stacked in sequence on the front surface of the semiconductor substrate 100. A highly doped region is provided on the emitter, and the second electrode is electrically connected to the highly doped region.

Still referring to FIG. 15, in an embodiment, a plurality of doped passivation layers 320 are provided, the solar cell further includes at least one barrier layer 402. The barrier layer 402 is located on a side of any of the doped passivation layers 320 away from the semiconductor substrate 100. The first end of the first electrode 700 extends to a target doped passivation layer 320 of the plurality of doped passivation layers 320 and extends through respective layers on a side of the target doped passivation layer 320 away from the semiconductor substrate 100. The layers through which the first electrode 700 extends include the dielectric layer 600.

In an embodiment, the layers through which the first electrode 700 extends further include at least one doped passivation layer 320 and/or at least one barrier layer 402.

In an embodiment, the barrier layer 402 has a thickness ranging from 0.5 nm to 10 nm.

In an embodiment, the thickness of the barrier layer 402 is greater than or equal to the thickness of the tunnel layer 200.

In an embodiment, the thickness of the tunnel layer 200 ranges from 0.5 nm to 2 nm.

In an embodiment, the thickness of the doped passivation layer 320 ranges from 2 nm to 50 nm.

Embodiments of the present application further provide a photovoltaic module, including a solar cell string. The solar cell string is formed by connecting a plurality of solar cells as described above.

In the description of the specification, the description with reference to the terms "some embodiments," "other embodiments," "ideal embodiments," and the like means that a particular feature, structure, material, or characteristic described in connection with the embodiment or example is included in at least one of the embodiments or examples of the present application. In the specification, illustrative descriptions of the above terms do not necessarily refer to the same embodiment or example.

The technical features in the above embodiments may be randomly combined. For concise description, not all possible combinations of the technical features in the above embodiments are described. However, all the combinations of the technical features are to be considered as falling within the scope described in this specification provided that they do not conflict with each other.

The above embodiments only describe several implementations of the present application, and their description is specific and detailed, but cannot therefore be understood as a limitation on the patent scope of the present application. It should be noted that those of ordinary skill in the art may further make variants and improvements without departing from the conception of the present application, and these all fall within the protection scope of the present application. Therefore, the patent protection scope of the present application shall be subject to the appended claims.

## Claims

1. A method for manufacturing a solar cell, comprising:
providing a semiconductor substrate (100);
forming a tunnel layer (200) on a surface of the semiconductor substrate (100);
sequentially forming an undoped initial intrinsic material layer (310) and a doped layer (401) comprising a dopant on a surface of the tunnel layer (200); the dopant comprising either an N-type dopant or a P-type dopant; and
performing heat treatment on the initial intrinsic material layer (310) and the doped layer (401) to diffuse the dopant in the doped layer (401) to the initial intrinsic material layer (310) and at least partially crystallize the initial intrinsic material layer (310), so as to convert the initial intrinsic material layer (310) into a doped passivation layer (320).

2. The method according to claim 1, wherein sequentially forming the undoped initial intrinsic material layer (310) and the doped layer (401) comprising the dopant on the surface of the tunnel layer (200) comprises:
alternately forming a plurality of undoped initial intrinsic material layers (310) and a plurality of doped layers (401) comprising the dopants on the surface of the tunnel layer (200).

3. The method according to claim 2, wherein one of the plurality of doped layers (401) that is furthest from the semiconductor substrate (100) is defined as a first doped layer (410), and another doped layer (401) except the first doped layer (410) is defined as a second doped layer (420);
the first doped layer (410) has a thickness ranging from 5 nm to 30 nm; and/or
the second doped layer (420) has a thickness ranging from 1 nm to 10 nm.

4. The method according to claim 3, wherein when the thickness of the first doped layer (410) is less than 10 nm, the method further comprises:
forming a mask layer on a surface of the first doped layer (410); a sum of thicknesses of the mask layer and the first doped layer (410) being greater than 20 nm;
and optionally wherein the mask layer is made of an undoped silicon compound.

5. The method according to claim 2, wherein one of the plurality of doped layers (401) that is furthest from the semiconductor substrate (100) is defined as a first doped layer (410), and another doped layer (401) except the first doped layer (410) is defined as a second doped layer (420);
a doping concentration of the second doped layer (420) is greater than a doping concentration of the first doped layer (410); and/or
a thickness of the first doped layer (410) is greater than a thickness of the tunnel layer (200), and a thickness of the second doped layer (420) is greater than or equal to the thickness of the tunnel layer (200).

6. The method according to claim 2, further comprising:
subsequent to performing heat treatment on the initial intrinsic material layer (310) and the doped layer (401), removing a barrier layer (402) formed by conversion of a first doped layer (410) during the heat treatment;
wherein the first doped layer (410) is one of the plurality of doped layers (401) that is furthest from the semiconductor substrate (100).

7. The method according to claim 2, wherein the doped layer (401) and the tunnel layer (200) are made of silicon oxide compounds,
one of the plurality of doped layers (401) that is furthest from the semiconductor substrate (100) is defined as a first doped layer (410), and another doped layer (401) except the first doped layer (410) is defined as a second doped layer (420), and
a silicon-to-oxygen ratio of a second doped layer (420) is greater than or equal to a silicon-to-oxygen ratio of a first doped layer (410) and the tunnel layer (200);
and optionally wherein the silicon-to-oxygen ratio of the second doped layer (420) is greater than 1:2, and the silicon-to-oxygen ratio of the tunnel layer (200) is less than 1:1.5.

8. The method according to any one of claims 1 to 7, wherein sequentially forming the undoped initial intrinsic material layer (310) and the doped layer (401) comprising the dopant on the surface of the tunnel layer (200) comprises:
forming the initial intrinsic material layer (310) and the doped layer (401) on the surface of the tunnel layer (200) in a same plasma enhanced chemical vapor deposition (PECVD) device;
and optionally wherein doping concentration of the doped layer (401) is greater than 1e21 atoms/cm³;
and more optionally wherein the tunnel layer (200) has a thickness ranging from 0.5 nm to 2 nm.

9. The method according to any one of claims 1 to 7, wherein the heat treatment is further configured to diffuse the dopant into the semiconductor substrate (100) to form an inner expansion layer (500) in the semiconductor substrate (100);
and optionally wherein conditions of the heat treatment comprise a heat treatment temperature greater than 800°C and a heat treatment time greater than 20 min;
and more optionally wherein the inner expansion layer (500) has a thickness ranging from 0.02 µm to 1 µm;
and even more optionally wherein the initial intrinsic material layer (310) is made of any one of intrinsic amorphous silicon, intrinsic microcrystalline silicon, and intrinsic polycrystalline silicon.

10. The method according to any one of claims 1 to 7, further comprising:
forming a buffer layer (403) in the initial intrinsic material layer (310); the buffer layer (403) comprising an undoped silicon compound; and
wherein performing heat treatment on the initial intrinsic material layer (310) and the doped layer (401) comprises:
performing heat treatment on the initial intrinsic material layer (310), the buffer layer (403), and the doped layer (401); the heat treatment comprising a plurality of treatment stages, temperatures in the plurality of treatment stages being partially the same;
and optionally wherein the heat treatment comprises a first treatment stage and a second treatment stage performed sequentially, and wherein a temperature in the second treatment stage is greater than a temperature in the first treatment stage, or the temperature in the second treatment stage is less than the temperature in the first treatment stage;
and more optionally wherein 800°C to 910°C is adopted in one of the first treatment stage and the second treatment stage, and 900°C to 1000°C is adopted in another of the first treatment stage and the second treatment stage.

11. The method according to claim 10, wherein the heat treatment comprises a first treatment stage, a second treatment stage, and a third treatment stage performed sequentially, and wherein a temperature in the second treatment stage is greater than a temperature in the first treatment stage and is greater than a temperature in the third treatment stage;
and optionally wherein when a plurality of initial intrinsic material layers (310) are provided, forming the buffer layer (403) in the initial intrinsic material layer (310) comprises:
forming the buffer layer (403) in one of the initial intrinsic material layers (310) that is closest to the semiconductor substrate (100);
and more optionally wherein the buffer layer (403) has a thickness ranging from 0.5 nm to 2 nm;
and even more optionally wherein the buffer layer (403) is made of a silicon oxide compound.

12. The method according to any one of claims 1 to 7, further comprising:
forming a dielectric layer (600) on a side of the doped passivation layer (320) away from the semiconductor substrate (100); and
forming a first electrode (700) on the side of the doped passivation layer (320) away from the semiconductor substrate (100), wherein a first end of the first electrode (700) extends through the dielectric layer (600) and is electrically connected to the doped passivation layer (320), and a second end of the first electrode (700) extends in a direction away from the semiconductor substrate (100);
and optionally wherein when a plurality of doped passivation layers (320) are provided, the first end of the first electrode (700) extends to a target doped passivation layer (320) of the plurality of doped passivation layers (320) and extends through respective layers on a side of the target doped passivation layer (320) away from the semiconductor substrate (100).

13. A solar cell, manufactured by using the method according to any one of claims 1 to 12, comprising:
a semiconductor substrate (100);
a tunnel layer (200) located on a surface of the semiconductor substrate (100);
a doped passivation layer (320) stacked on a side of the tunnel layer (200) away from the semiconductor substrate (100);
a dielectric layer (600) disposed on a side of the doped passivation layer (320) away from the tunnel layer (200); and
a first electrode (700), a first end of the first electrode (700) being electrically connected to the doped passivation layer (320) and extending through the dielectric layer (600), and a second end of the first electrode (700) extending in a direction away from the semiconductor substrate (100).

14. The solar cell according to claim 13, wherein a plurality of doped passivation layers (320) are provided, and
the solar cell further comprises at least one barrier layer (402) located on a side of any of the doped passivation layers (320) away from the semiconductor substrate (100); and
the first end of the first electrode (700) extends to a target doped passivation layer (320) of the plurality of doped passivation layers (320) and extends through respective layers on a side of the target doped passivation layer (320) away from the semiconductor substrate (100); and the layers through which the first electrode (700) extends comprise the dielectric layer (600);
and optionally wherein the layers through which the first electrode (700) extends further comprise at least one of the doped passivation layers (320) and/or the at least one barrier layer (402);
and more optionally wherein the barrier layer (402) has a thickness ranging from 0.5 nm to 10 nm;
and even more optionally wherein a thickness of the barrier layer (402) is greater than or equal to a thickness of the tunnel layer (200).

15. The solar cell according to claim 13, wherein the tunnel layer (200) has a thickness ranging from 0.5 nm to 2 nm;
and optionally wherein the doped passivation layer (320) has a single-layer thickness ranging from 2 nm to 150 nm.

16. A photovoltaic module, comprising a solar cell string, the solar cell string being formed by connecting a plurality of solar cells according to any one of claims 12 to 15.
